# EUROPEAN PATENT APPLICATION

(11) **EP 1 662 853 A2**
(43) Date of publication of application: **31.05.2006**
(21) Application number: 05257170.0
(22) Date of filing: 22.11.2005
(51) Int. Cl.: H05K 9/00

(54) **Electronic apparatus comprising a tuner circuit board with a detachable grounding section**

(30) Priority: 25.11.2004 JP 2004339957
(71) Applicant: ORION ELECTRIC CO., Ltd., Fukui 915-8555 (JP)
(72) Inventor: Kakiuchi, Atsushi c/o Orion Electric Co., Ltd., Echizen-city Fukui 915-8555 (JP)
(74) Representative: Paget, Hugh Charles Edward

(57) **Abstract**

To provide an electronic apparatus having a tuner circuit board that can prevent undesirable radiation, is laid out to allow a hybrid tuner designed both for digital broadcasting and analog broadcasting to be mounted. On a tuner circuit board 30 having a tuner section 130 on which a vertical-type tuner 41 and a horizontal-type tuner 42 can interchangeably mounted, an IF block 142 and an MPEG IC 140 are disposed at a distance from a power supply section 150, a grounding section 170 extending from the tuner section 130 is provided. In the case of the vertical-type tuner 41, the grounding section 170 is separated off by a tear-off line 173. In the case of the horizontal-type tuner 42, the grounding section 170 is not separated off so that the grounding section 170 reduces the effect of an undesirable radiation emitted by the mounted horizontal-type tuner 42.

## Description

### BACKGROUND OF THE INVENTION

### Field of the Invention

The present invention relates to an electronic apparatus having a tuner circuit board on which a hybrid tuner designed both for digital broadcasting and analog broadcasting can be mounted that is used in a television set with display means of CRT type, liquid crystal type or plasma display panel (PDP) type, a recording/reproducing device such as DVD and HDD, or a composite electronic apparatus incorporating the television set and the recording/reproducing device, and to such an electronic apparatus.

### Description of the Related Art

Conventionally, as for an electronic apparatus having a receiver circuit designed for digital broadcasting, for example, when fabricating a tuner circuit board and making noise evaluation and investigation of undesirable radiations from a video/audio processing section that processes a video/audio signal of digital and analog broadcasting and from a tuner in an experimental stage, separate tuner circuit boards for a vertical-type tuner and a horizontal-type tuner have to be fabricated, in order to make the evaluation and investigation for both the cases of the vertical-type tuner and the horizontal-type tuner. Such separate tuner circuit boards have different layouts, circuit arrangements and wiring patterns of a tuner section on which the tuner is mounted, the video/audio processing section including a digital signal, a power supply section or the like. Thus, a plurality of kinds of tuner circuit boards for mass production, which are fabricated based on the experimental tuner circuit boards, have to be fabricated for different electronic apparatus.

With regard to circuit boards for such a digital broadcasting receiving unit and a digital broadcasting receiver, as a conventional technique for sharing a circuit board among different digital broadcasting receivers, for example, Japanese Patent Laid-Open Publication No. 2000-299576 (patent document 1) discloses a method of providing different digital broadcasting receivers with digital broadcasting receiver circuit boards configured substantially the same that have a unit mounting section on which a plurality of digital broadcasting receiving units composed of at least a tuner circuit, a demodulation circuit and an error correction circuit are mounted.

In the conventional technology, a tuner circuit board on which a hybrid tuner designed both for digital broadcasting and analog broadcasting is mounted is provided with undesirable radiation preventing means, and in the experimental stage, and the effects of the undesirable radiation emitted from a video/audio processing section of the tuner circuit board that processes a video/audio signal of digital broadcasting or analog broadcasting and the undesirable radiation emitted from the tuner are evaluated and investigated. To do this according to a conventional technique, and to make an evaluation for a vertical-type tuner and a horizontal-type tuner, a tuner circuit board for the vertical-type tuner and a tuner circuit board for the horizontal-type tuner have to be separately fabricated. Such separately fabricated tuner circuit boards are different from each other in layout, circuit arrangement and wiring pattern, and the wiring pattern and the circuit arrangement have an effect on the investigation result. Thus, the tuner circuit boards have to be dealt with and investigated separately, which imposes a burden on engineers. In addition, the circuits, patterns, boards, shielding plates or the like of such separately fabricated tuner circuit boards have to be dealt with individually. Furthermore, the variety of tuner circuit boards for mass production, which are fabricated after the evaluation and investigation described above, is increased because one tuner circuit board has to be prepared for each of various electronic apparatus, the load of management of a stock of circuit boards increases, the circuit board cost varies, and grounding of the circuit board has to be assured within a limited space.

### SUMMARY OF THE INVENTION

The present invention is to provide an electronic apparatus having a tuner circuit board that can highly prevent undesirable radiation, is laid out to allow a hybrid tuner designed both for digital broadcasting and analog broadcasting to be mounted thereon regardless of whether the hybrid tuner is a vertical-type tuner or a horizontal-type tuner, allows investigation of an undesirable radiation emitted by the tuner in the experimental stage and can be dedicated to either the vertical-type tuner or the horizontal-type tuner in mass production.

The electronic apparatus having the tuner circuit board as set forth in Claim 1, the tuner circuit board comprising: a tuner section on which a hybrid tuner designed both for digital broadcasting and analog broadcasting can be mounted; a video/audio processing section that processes a received video/audio signal of digital broadcasting or analog broadcasting; an input/output connecting section connected to a main circuit board of the electronic apparatus; and a power supply section that supplies electric power to each section on the circuit board, is characterized in that both a vertical-type tuner and a horizontal-type tuner designed both for digital broadcasting and analog broadcasting can be mounted on the tuner section of the tuner circuit board, the tuner circuit board has, as the undesirable radiation preventing means, a grounding section that extends from one edge of the tuner circuit board at the side of the tuner section in a direction of protrusion of the horizontal-type tuner, separating means having a tear-off line is provided at the boundary between the grounding section and the tuner circuit board, the grounding section can be separated off by the separating means when the vertical-type tuner is mounted on the tuner circuit board, and the grounding section is not separated off so that a part of the horizontal-type tuner at the side of a receiving input terminal thereof protrudes above the grounding section when the horizontal-type tuner is mounted on the tuner circuit board.

According to an arrangement as set forth in Claim 1, in the electronic apparatus having the tuner circuit board, the tuner circuit board comprising: a tuner section on which a hybrid tuner designed both for digital broadcasting and analog broadcasting can be mounted; a video/audio processing section that processes a received video/audio signal of digital broadcasting or analog broadcasting; an input/output connecting section connected to a main circuit board of the electronic apparatus; and a power supply section that supplies electric power to each section on the circuit board, both a vertical-type tuner and a horizontal-type tuner designed both for digital broadcasting and analog broadcasting can be mounted on the tuner section of the tuner circuit board, the tuner circuit board has, as the undesirable radiation preventing means, a grounding section that extends from one edge of the tuner circuit board at the side of the tuner section in a direction of protrusion of the horizontal-type tuner, separating means having a tear-off line is provided at the boundary between the grounding section and the tuner circuit board, the grounding section can be separated off by the separating means when the vertical-type tuner is mounted on the tuner circuit board, and the grounding section is not separated off so that a part of the horizontal-type tuner at the side of a receiving input terminal thereof protrudes above the grounding section when the horizontal-type tuner is mounted on the tuner circuit board. Since the grounding pattern is formed in the area of the tuner circuit board that lies under the horizontal-type tuner and would otherwise be discarded as an unnecessary part or would otherwise be an useless area without any grounding pattern, an undesirable radiation can be absorbed by the grounding section and be stabilized.

The electronic apparatus having the tuner circuit board as set forth in Claim 2 is the electronic apparatus having the tuner circuit board as set forth in Claim 1, characterized in that when evaluating and investigating the undesirable radiations of the vertical-type tuner and the horizontal-type tuner, the undesirable radiations of the tuner circuit board having the vertical-type tuner and the tuner circuit board having the horizontal-type tuner can be evaluated and investigated by alternately mounting the vertical-type tuner and the horizontal-type tuner on the tuner circuit board without the grounding section being separated off.

According to an arrangement as set forth in Claim 2, when evaluating and investigating the undesirable radiations of the vertical-type tuner and the horizontal-type tuner, the undesirable radiations of the tuner circuit board having the vertical-type tuner and the tuner circuit board having the horizontal-type tuner can be evaluated and investigated by alternately mounting the vertical-type tuner and the horizontal-type tuner on the tuner circuit board without the grounding section being separated off. Thus, there is no need of fabricating a plurality of experimental tuner circuit boards for evaluation, and evaluation and investigation of the undesirable radiation can be readily performed simply by alternately mounting the vertical-type tuner and the horizontal-type tuner on one tuner circuit board with an electronic component mounted thereon.

The electronic apparatus having the tuner circuit board as set forth in Claim 3 is the electronic apparatus having the tuner circuit board as set forth in Claim 1 or 2, characterized in that after evaluation and investigation of the undesirable radiation are completed, if the tuner to be used for mass production is the vertical-type tuner, the grounding section can be separated off by the separating means, or if the tuner to be used for mass production is the horizontal-type tuner, the grounding section is not separated off so that the part of the horizontal-type tuner at the side of the receiving input terminal thereof protrudes above the grounding section, thereby providing a tuner circuit board for mass production on which a predetermined tuner selected from among a plurality of kinds of tuners is mounted and which is dedicated to a plurality of kinds of electronic apparatus.

According to an arrangement as set forth in Claim 3, after evaluation and investigation of the undesirable radiation are completed, if the tuner to be used for mass production is the vertical-type tuner, the grounding section can be separated off by the separating means, or if the tuner to be used for mass production is the horizontal-type tuner, the grounding section is not separated off so that the part of the horizontal-type tuner at the side of the receiving input terminal thereof protrudes above the grounding section, thereby providing a tuner circuit board for mass production on which a predetermined tuner selected from among a plurality of kinds of tuners is mounted and which is dedicated to a plurality of kinds of electronic apparatus. Thus, the number of steps required for purchase of materials of the board and electronic components, inventory management thereof, and start of mountings of the electronic components can be reduced.

The electronic apparatus having the tuner circuit board as set forth in Claim 4 is the electronic apparatus having the tuner circuit board as set forth in any one of Claims 1 to 3, characterized in that the tuner circuit board has a circuit arrangement that allows the tuner circuit board to be shared by the vertical-type tuner and the horizontal-type tuner, and the pattern on the circuit board is the same for the vertical-type tuner and the horizontal-type tuner.

According to an arrangement as set forth in Claim 4, the tuner circuit board has a circuit arrangement that allows the tuner circuit board to be shared by the vertical-type tuner and the horizontal-type tuner, and the pattern on the circuit board can be the same for the vertical-type tuner and the horizontal-type tuner. Thus, the time for evaluation and investigation of the prototype can be reduced, and the complexity of the work of engineers in the development stage can be reduced.

The electronic apparatus having the tuner circuit board as set forth in Claim 5 is the electronic apparatus having the tuner circuit board as set forth in any one of Claims 1 to 4, characterized in that the area of the grounding section that overlaps with the protruding part of the horizontal-type tuner at the side of the receiving input terminal is an overlapping area of the grounding section, and the area of the grounding section that lies on the other side of the receiving input terminal of the protruding horizontal-type tuner and does not overlap with the horizontal-type tuner is a free area in which no electronic component or the like is placed.

According to an arrangement as set forth in Claim 5, since the area of the grounding section that overlaps with the protruding part of the horizontal-type tuner at the side of the receiving input terminal is an overlapping area of the grounding section, the receiving input terminal of the horizontal-type tuner, which is easily affected by the undesirable radiation because it protrudes from a shield covering the tuner, is disposed close to the overlapping area of the grounding section after the horizontal-type tuner is mounted on the tuner circuit board, so that the undesirable radiation can be absorbed by the grounding section and thus can be prevented. Furthermore, since the area of the grounding section that lies on the other side of the receiving input terminal of the protruding horizontal-type tuner and does not overlap with the horizontal-type tuner is a free area in which no electronic component or the like is placed, the area in the rear of the horizontal-type tuner can be an area that is hardly affected by the undesirable radiation.

The electronic apparatus having the tuner circuit board as set forth in Claim 6 is electronic apparatus having the tuner circuit board as set forth in any one of Claims 1 to 5, characterized in that one grounding pattern is formed over substantially the whole surface of the grounding section extending from the tuner circuit board.

According to an arrangement as set forth in Claim 6, one grounding pattern is formed over substantially the whole surface of the grounding section extending from the tuner circuit board. Thus, the undesirable radiation can be efficiently absorbed by substantially the whole area of the wide grounding section.

The electronic apparatus having the tuner circuit board as set forth in Claim 7 is the electronic apparatus having the tuner circuit board as set forth in any one of Claims 1 to 6, characterized in that the video/audio processing section of the tuner circuit board has a digital circuit block and an IF block, when the tuner circuit board is connected to the main circuit board of the electronic apparatus, the digital circuit block and the IF block are disposed at a distance from the power supply section, and an input connector for supplying electric power from the main circuit board of the electric apparatus to the tuner circuit board and an input connector grounded via the main circuit board of the electronic apparatus are disposed close to the power supply section.

According to an arrangement as set forth in Claim 7, since the video/audio processing section of the tuner circuit board has a digital circuit block and an IF block, and when the tuner circuit board is connected to the main circuit board of the electronic apparatus, the digital circuit block and the IF block are disposed at a distance from the power supply section, the power supply section can be spaced apart from the digital circuit block and the IF block that are likely to emit an undesirable radiation, which is emitted by a digital circuit system and a harmonic signal system, thereby reducing the effect of the undesirable radiation. Furthermore, since an input connector for supplying electric power from the main circuit board of the electric apparatus to the tuner circuit board and an input connector grounded via the main circuit board of the electronic apparatus are disposed close to the power supply section, the length of a connection line from the electronic apparatus and the wiring pattern on the tuner circuit board can be minimized, so that the effect of the digital circuit block and the IF block, which are likely to emit an undesirable radiation, can be minimized.

The electronic apparatus having the tuner circuit board as set forth in Claim 8 is the electronic apparatus having the tuner circuit board as set forth in any one of Claims 1 to 7, characterized in that in the case where the horizontal-type tuner, whose receiving input terminal is close to the surface of the tuner circuit board, is mounted, and the spatial distance between the receiving input terminal and a wiring pattern on the tuner circuit board is short, the power supply section is disposed at a distance from the receiving input terminal of the horizontal-type tuner, and a free area in which no electronic component is placed is provided in the vicinity of the power supply section.

According to an arrangement as set forth in Claim 8, in the case where the horizontal-type tuner, whose receiving input terminal is close to the surface of the tuner circuit board, is mounted, and the spatial distance between the receiving input terminal and a wiring pattern on the tuner circuit board is short, the power supply section is disposed at a distance from the receiving input terminal of the horizontal-type tuner, and a free area in which no electronic component is placed is provided in the vicinity of the power supply section. Since the receiving input terminal of the horizontal-type tuner is disposed close to the digital circuit block and the IF block, and the receiving input terminal absorbs, stabilizes and emits the undesirable radiation emitted from the digital circuit block and the IF block, the power supply section, which is easily affected by the undesirable radiation, is disposed at a distance from the receiving input terminal, and the free area is formed in the grounding section to absorb the undesirable radiation, thereby reducing the effect of the undesirable radiation on the power supply section.

The electronic apparatus having the tuner circuit board as set forth in Claim 9 is the electronic apparatus having the tuner circuit board as set forth in any one of Claims 1 to 8, characterized in that a shielding place that covers the tuner circuit board can be shared by either of the vertical-type tuner and the horizontal-type tuner.

According to an arrangement as set forth in Claim 9, since a shielding place that covers the tuner circuit board can be shared by the vertical-type tuner and the horizontal-type tuner, only one sharable shielding plate, which can be used as a cover for a plurality of kinds of tuner circuit boards that are likely to emit an undesirable radiation, is enough to reduce the effect of the undesirable radiation on the main circuit board or the like of the electronic apparatus.

### BRIEF DESCRIPTION OF THE DRAWINGS

FIG. 1 is a block diagram showing a schematic arrangement of a tuner circuit board on which a vertical-type tuner and a horizontal-type tuner can be mounted according to an embodiment of the present invention.
FIG. 2 is a plan view of the tuner circuit board on which the vertical-type tuner and the horizontal-type tuner can be mounted according to the present invention.
FIG. 3 is a perspective view of the tuner circuit board on which the vertical-type tuner is mounted according to the present invention.
FIG. 4 is a perspective view of the tuner circuit board on which the horizontal-type tuner is mounted according to the present invention.
FIG. 5 is a plan view of a tuner circuit board on which a vertical-type tuner is mounted in mass production according to the present invention.
FIG. 6 is a plan view of a horizontal-type tuner circuit board on which a horizontal-type tuner is mounted in mass production according to the present invention.
FIG. 7 is a perspective view of a tuner circuit board on which a vertical-type tuner covered with a shielding plate, which can be used both for the vertical type and the horizontal type, is mounted.

### DETAILED DESCRIPTION OF THE PREFERRED EMBODIMENTS

As described above, essentially, the present invention provides a tuner circuit board having undesirable radiation preventing means on which a hybrid tuner designed both for digital broadcasting and analog broadcasting is mounted that is used in a television set with display means of CRT type, liquid crystal type or PDP type, a recording/reproducing device such as DVD and HDD, or a composite electronic apparatus incorporating the television set and the recording/reproducing device. However, the hybrid tuner may be a vertical-type tuner or horizontal-type tuner, and in the following, an embodiment of the present invention will be described in which not only the vertical-type tuner and the horizontal-type tuner mounted on the tuner circuit board can be interchanged, but also the tuner circuit boards with an electronic component mounted thereon on which the vertical-type tuner and the horizontal-type tuner are mounted can be interchanged.

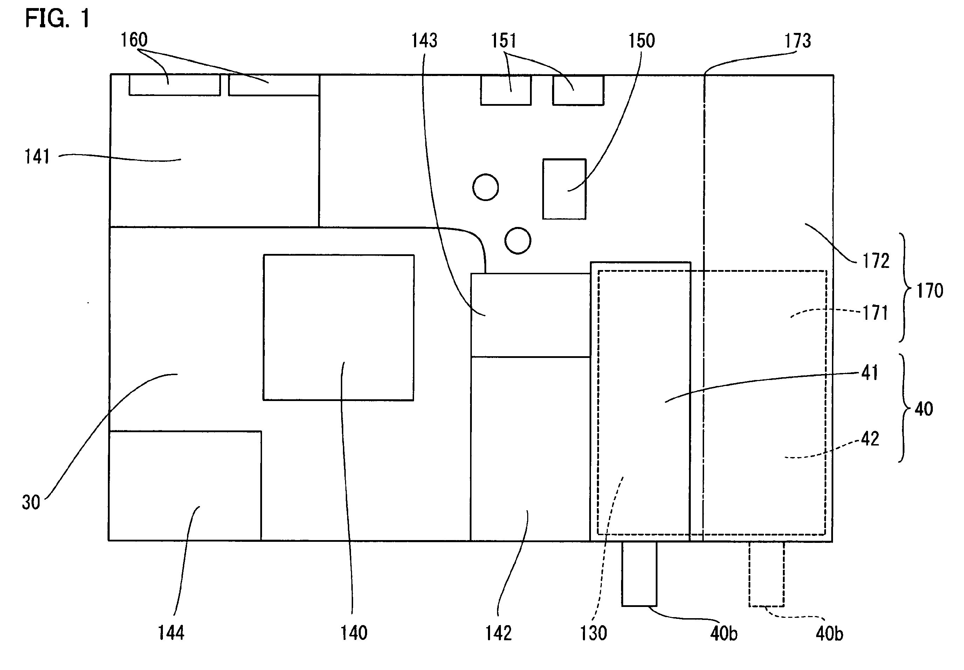

In the following, an embodiment of the present invention, which is a best mode for carrying out the invention, will be described with reference to FIGS. 1 to 7. Of course, the present invention can be readily applied to other types of apparatus or device than those described in the following without departing from the spirit thereof.

FIG. 1 is a schematic block diagram showing a tuner circuit board according to an embodiment of the present invention on which a vertical-type tuner or a horizontal-type tuner can be mounted.

As shown in the block diagram of FIG. 1, the tuner circuit board comprises: a tuner section 130 on which a hybrid tuner 40 designed both for digital broadcasting and analog broadcasting that extracts a target broadcasting signal frequency from channels of digital broadcasting and analog broadcasting and converts the selected frequency into an audible frequency can be mounted, an IF block 142 that amplifies, modulates or decodes an intermediate frequency signal of digital broadcasting signals, a flash memory section 143 that storage control data for a main microcomputer circuit described later including frequency information about each piece of channel data concerning digital or analog broadcasting, a main microcomputer/MPEG IC 140 having an MPEG circuit that combines received digital video/audio signals and the main microcomputer circuit that controls each section of the tuner circuit board, an SDRAM section 144 that is a memory that communicates with the main microcomputer circuit and retains the received video/audio signals, selected channel data or the like for a short time during processing of the video/audio signals, a decoder block 141 that performs a processing of converting the received analog video/audio signals into digital video/audio signals and performs a processing of communicating with the main microcomputer circuit, an input/output connector 160 that outputs the video/audio signals having been processed by the MPEG circuit in the main microcomputer/MPEG IC 140 and the decoder block 141 to a main circuit board of a television set (not shown) and receives a receiving operation instruction from the television set, a power supply block 150 that supplies electrical power to each section of the tuner circuit board 30, an input connector 151 that receives electrical power from the television set, and an input connector 151 that is grounded.

In addition, on the tuner section 130 located in a lower right area of the tuner circuit board 30 shown in FIG. 1, there is mounted a vertical-type tuner 41 capable of receiving both the digital broadcasting and the analog broadcasting, and a receiving input terminal 40b of the vertical-type tuner 41 is shown as extending downward in a lower part of FIG. 1. In addition, FIG. 1 shows by the dashed line that, on the tuner section 130, a horizontal-type tuner 42 capable of receiving both the digital broadcasting and the analog broadcasting can be mounted in such a position that a receiving input terminal 40b of the horizontal-type tuner 42 is located in a lower right area of FIG. 1. Furthermore, the tuner circuit board 30 has a grounding section 170 disposed at the right of the tuner section 130 in FIG. 1, and a tear-off line 173 is formed at the boundary between the tuner circuit board 30 and the grounding section 170. Thus, when the vertical-type tuner 41 is mounted, the tear-off line 173 allows the tuner circuit board 30 and the grounding section 170 to be used separately, while when the horizontal-type tuner 42 is used, the grounding section 170 is not separated from the tuner circuit board 30 and a part of the horizontal-type tuner 42 close to the receiving input terminal 40b thereof can protrude above the grounding section 170. The area of the grounding section that overlaps with the protruding horizontal-type tuner 42 is referred to as overlapping area 171 of the grounding section, and the area of the grounding section 170 that does not overlap with the protruding horizontal-type tuner 42, which lies on the other hand of the receiving input terminal 40b of the horizontal-type tuner 42 is referred to as free area 172 in which no electronic component or the like is placed. In this way, the grounding section 170 is provided by forming a grounding pattern in the area of the tuner circuit board 30 that lies under the horizontal-type tuner 42 and would otherwise be discarded as an unnecessary part or would otherwise be an useless area without any wiring pattern, and thus, the undesirable radiation can be absorbed by the grounding section 170.

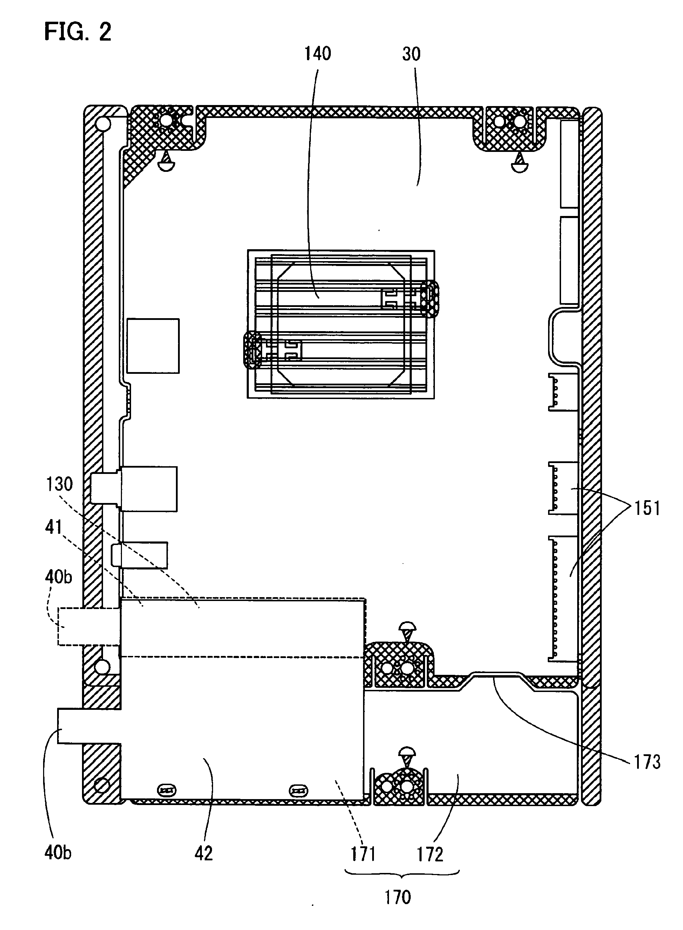

FIG. 2 is a plan view of the tuner circuit board on which the vertical-type tuner 41 and the horizontal-type tuner 42 can be mounted.

FIG. 2 shows the positions of the vertical-type tuner 41 and the horizontal-type tuner 42 mounted on the tuner circuit board 30, in which the solid line indicates the position of the horizontal-type tuner 42, and the dashed line indicates the position of the vertical-type tuner 41. It is shown that, in an experimental stage, once an electronic component (not shown) is mounted on the tuner circuit board 30, the effect of an undesirable radiation can be evaluated using the same wiring pattern and the same electronic component by alternately mounting the horizontal-type tuner 42 and the vertical-type tuner 41 on the tuner circuit board 30. In addition, the grounding section 170 is disposed at the lower side of the tuner section 130 in FIG. 2. The grounding section 170 has a copper-foil pattern formed over substantially the whole surface thereof, so that no electronic component can be mounted on the grounding section 170. In addition, the tuner section 130 shown in FIG. 2 has a plurality of terminal openings through which connection terminals (not shown) of the plurality of tuners 41, 42 are inserted for soldering, and the vertical-type tuner 41 is mounted in the tuner section 130 and soldered at the back side of the tuner section 130 via the terminal openings. In the case where the horizontal-type tuner 42 is mounted, once the horizontal-type tuner 42 is soldered at the back side of the tuner section 130 via the terminal openings, a part of the horizontal-type tuner 42 close to the receiving input terminal 40b thereof protrudes above the grounding section 170 disposed at the right of the tuner section 130 in FIG. 2, the part of the grounding section lies under the protruding horizontal-type tuner 42 constitutes the overlapping area 171. Supposing that the side of the grounding section 170 close to the receiving input terminal 40b of the horizontal-type tuner 42 is the front side, the rear-side part of the grounding section 170 constitutes the free area 172 on which no electronic component can be mounted, as described above.

In the experimental stage described above, without the tuner circuit board 30, which can be separated from the grounding section 170 along the tear-off line 173, being separated, and with an electronic component (not shown) being mounted on the tuner circuit board 30, the effect of the undesirable radiation is evaluated for the tuner circuit board 30 on which the vertical-type tuner 41 or the horizontal-type tuner 42 is mounted. Then, a plurality of kinds of vertical-type tuners 41 or horizontal-type tuners 42, which are different from the vertical-type tuner 41 and the horizontal type tuner 42 described above, are alternately mounted on the tuner circuit board 30 whose wiring pattern and electronic components mounted thereon are not changed, and the effect of the undesirable radiation can be evaluated for various combinations of the tuner circuit board 30 and the tuners 41, 42. Thus, since the conditions are not changed except for the tuners 41, 42, the effect of the undesirable radiation can be readily determined for various combinations of one tuner circuit board 30 and the tuners 41, 42. Thus, developers or designers no longer need to fabricate a plurality of kinds of tuner circuit boards 30 having different wiring patterns or electronic components to be mounted, evaluate prototypes based on various combinations of the plurality of tuner circuit boards 30 and the plurality of tuners 41, 42, investigate the complicated results of evaluation of the various combinations, or take individual measures based on the complicated evaluation results. Accordingly, the development time can be reduced, the workload on developers or engineers can be reduced, and the development and design cost can be reduced significantly. In addition, the degree of freedom of design can be increased, because the electronic apparatus (not shown), such as a television set, can be designed regardless of which tuner is selected from among the plurality of tuners 41, 42.

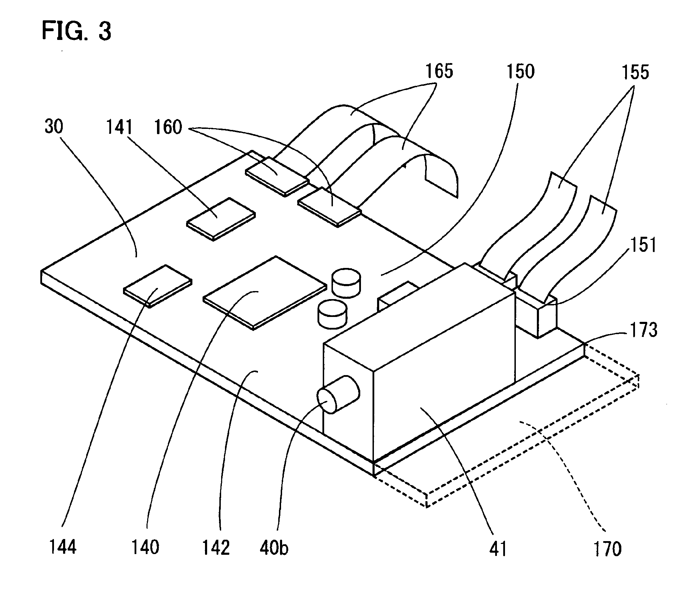

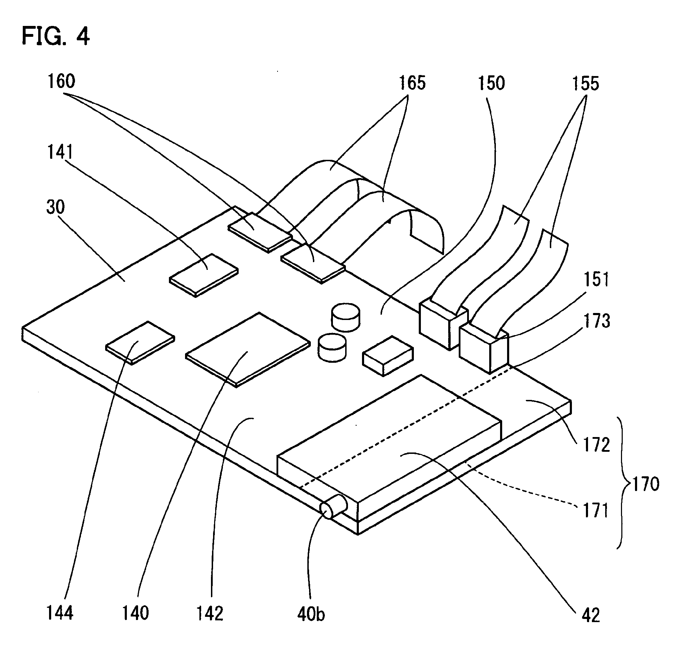

FIG. 3 is a perspective view of a tuner circuit board on which a vertical-type tuner is mounted, and FIG. 4 is a perspective view of a tuner circuit board on which a horizontal-type tuner is mounted. FIGS. 3 and 4 show the tuner circuit board 30 described with reference to FIG. 1 on which the vertical-type tuner 41 and the horizontal-type tuner 42 are mounted, respectively, and on which electronic components including the main microcomputer/MPEG IC 140, the SDRAM 144 and the input connectors 151, 160 are mounted.

FIG. 3 shows, by the dashed line, that the grounding section 170 disposed at the right of the tuner circuit board 30 on which the vertical-type tuner 41 is mounted has been separated along the tear-off line 173. In the case where the vertical-type tuner 41 is mounted, a predetermined spatial distance is maintained between the receiving input terminal 40b of the vertical-type tuner 41 and the wiring pattern on the tuner circuit board 30, so that there is no need of providing the grounding section 170 near the vertical-type tuner 41, and thus, the grounding section 170 is separated. The power supply block 150 is disposed in the rear of the vertical-type tuner 41, or in the upper right area of FIG. 3, and the input connectors 151, to which a connection line 155 for receiving power supply from a main circuit board of a television set (not shown) and a connection line 155 grounded are connected, are disposed in the rear of the power supply block 150. The power supply block 150 and the input connectors 151 are disposed at a distance from the main microcomputer/MPEG IC 140, the decoder block 141 and the IF block 142, which emit an undesirable radiation, and the input connector 151 for receiving power supply and the input connector 151 grounded are disposed at the rear of the power supply block 150 and connected thereto in the shortest distance, thereby reducing the effect of the undesirable radiation on the input connectors 151.

Referring to FIG. 4, the grounding section 170, which is indicated by the dashed line in FIG. 3, is not separated from the tuner circuit board 30 on which the horizontal-type tuner 42 is mounted, and the grounding section 170 has the overlapping area 171 that overlaps with the horizontal-type tuner 42 and the free area 172 that does not overlap with the horizontal-type tuner 42 and on which no electronic component is mounted. The tuner circuit board 30 on which the horizontal-type tuner 42 is mounted has the same wiring pattern and the same electronic components disposed thereon as the tuner circuit board 30 on which the vertical-type tuner 41 is mounted shown in FIG. 3 and differs from the tuner circuit board 30 only in that the grounding section 170 is not separated off and the horizontal-type tuner 42 is mounted instead of the vertical-type tuner 41. In the tuner circuit board 30 on which the horizontal-type tuner 42 is mounted, the receiving input terminal 40b of the horizontal-type tuner 42 is disposed close to the surface of the tuner circuit board 30, so that an adequate spatial distance cannot be maintained between the receiving input terminal 40b and the wiring pattern on the tuner circuit board 30. Thus, there is a possibility that a noise occurs due to the undesirable radiation emitted from the wiring pattern connected to the IF block 142, the decoder block 141 and the main microcomputer/MPEG IC 140 adjacent to the tuner section 130 on which the horizontal-type tuner 42 is mounted. Thus, in order to eliminate the problem of noise, the power supply block 150, which is easily affected by the undesirable radiation, is disposed at a distance from the receiving input terminal 40b, a grounding pattern is formed on substantially the whole surface of the grounding section 170, and the free area 172, on which no electronic component is mounted, is provided in the rear of the horizontal-type tuner 42 so that an undesirable radiation emitted by the receiving input terminal 40b of the horizontal-type tuner 42, which is possibly affected by the undesirable radiation, is absorbed by the free area 172 formed in the ground section 170 and stabilized, thereby reducing the effect of the undesirable radiation on the power supply block 150 and the receiving input terminal 40b. In this way, even when the horizontal-type tuner 42 is mounted, and the tuner circuit board 30 has a disadvantageous arrangement in which an adequate distance is not maintained between the receiving input terminal 40b and the surface of the tuner circuit board 30, the tuner circuit board 30 can be highly resistant to the undesirable radiation or noise. In addition, the undesirable radiation can be efficiently absorbed over the whole area of the wide grounding section 170.

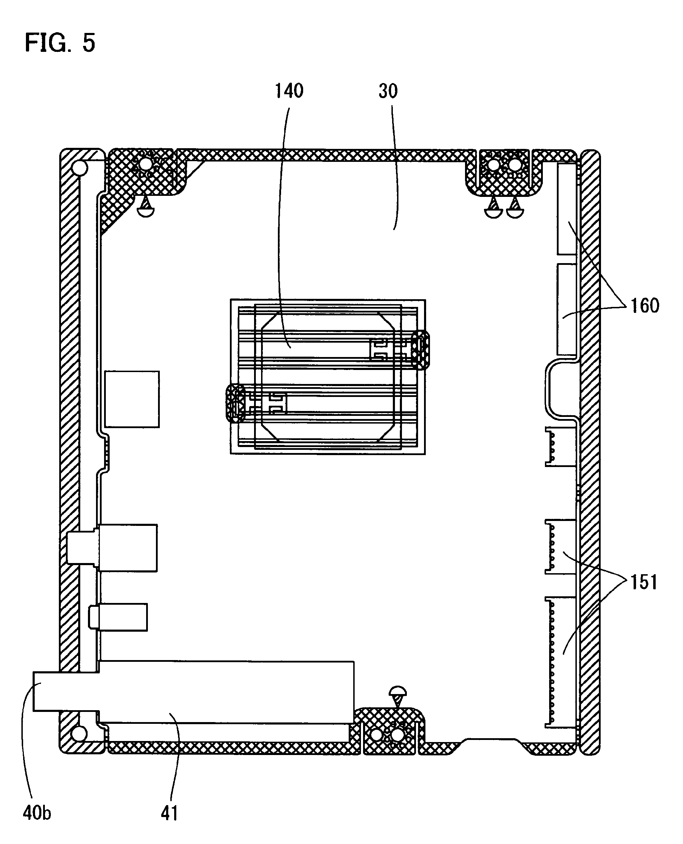

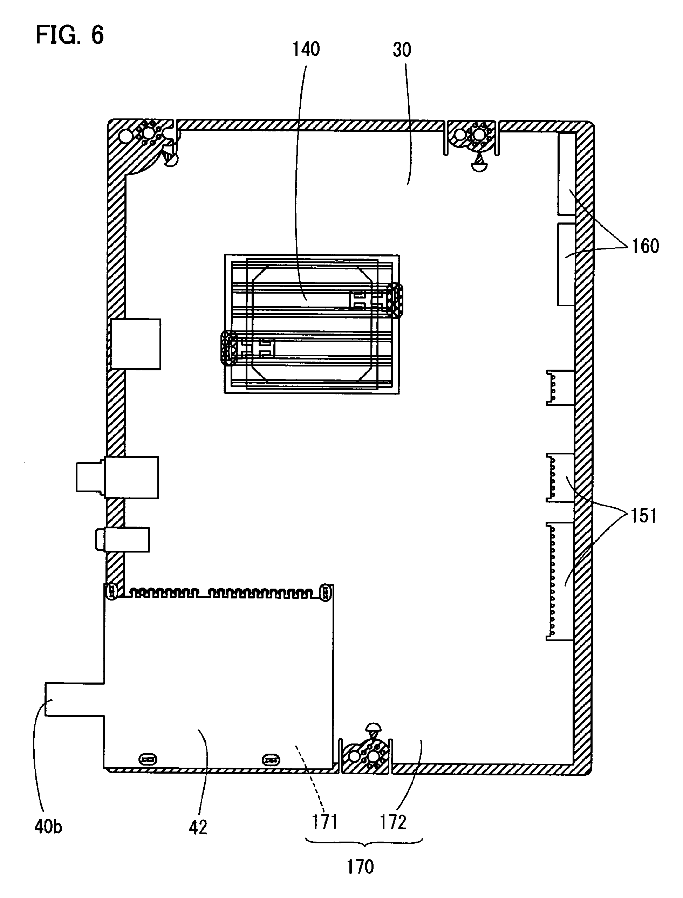

Now, with reference to FIGS. 5 and 6, a tuner circuit board for mass production fabricated based on the tuner circuit board in the experimental stage will be described. FIG. 5 is a plan view of a tuner circuit board on which a vertical-type tuner is mounted in mass production, and FIG. 6 is a plan view of a tuner circuit board on which a horizontal-type tuner is mounted in mass production.

The tuner circuit board 30 on which the vertical-type tuner 41 is mounted shown in FIG. 5 is the tuner circuit board 30 shown in FIG. 2 with the grounding section 170 being separated off. As described above, the vertical-type tuner circuit board 30 for mass production has the same configuration as the tuner circuit board 30 in the experimental stage shown in FIG. 2, and the tuner circuit board 30 has the same wiring pattern and the same electronic components disposed thereon as those described above except that the vertical-type tuner 41 mounted on the tuner circuit board 30 is selected from among a plurality of tuners 41, 42. Thus, the tuner circuit board 30 shown in FIG. 2 with the grounding section 170 being separated off can be used for mass production, and thus, there is no need to design a new tuner circuit board 30 for mass production, and the number of steps required for purchase of materials of the board and electronic components, inventory management thereof, and start of mountings of the electronic components can be reduced.

Now, the tuner circuit board 30 on which the horizontal-type tuner 42 is mounted shown in FIG. 6 will be described. The tuner circuit board 30 differs from the tuner circuit board 30 shown in FIG. 2 in that there is no tear-off line 173 formed at the boundary between the grounding section 170 and the tuner circuit board 30. However, the wiring pattern formed on the tuner circuit board 30 has the same configuration as that on the tuner circuit board 30 shown in FIG. 2. Thus, referring to the lower side area of FIG. 6, the grounding section 170 is formed integrally with the tuner circuit board 30. In this way, the tuner circuit board 30, which would be reduced in strength and possibly be damaged if the tear-off line 173 is formed at the boundary between the grounding section 170 and the tuner circuit board 30, is prevented from being damaged during mass production. Thus, as described above, the receiving input terminal 40b of the horizontal-type tuner 42 shown in FIG. 4 is spaced apart from the power supply block 150, and the area of the grounding section 170 in the rear of the horizontal-type tuner 42 constitutes the free area 172, in which no electronic component is mounted. Thus, there is no need to design a new tuner circuit board 30 for mass production, and the tuner circuit board 30 that is comparable in undesirable radiation preventive effect to the tuner circuit board 30 having been evaluated in the experimental stage can be used for mass production. Thus, the unevenness in quality among electronic apparatus incorporating the tuner circuit board 30 (not shown), such as television sets, can be reduced.

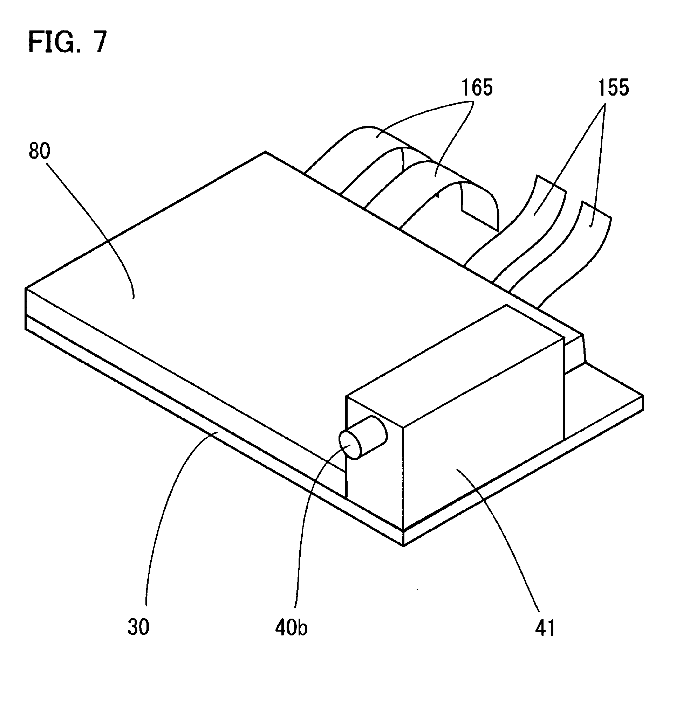

FIG. 7 is a perspective view of a tuner circuit board on which a vertical-type tuner covered with a shielding plate, which can be used both for the vertical type and the horizontal type, is mounted.

A shielding plate 80 shown in FIG. 7 has a box-like shape and is disposed to cover the top of the tuner circuit board 30 and the electronic components mounted thereon. The shielding plate 80 covers the tuner circuit board 30 in such a manner that an edge of the shielding plate 80 is close to but kept off the raised vertical-type tuner 41 mounted on the tuner circuit board 30, and in a side of the shielding plate 80, there are formed openings (not shown) through which a connection line 165 connected to the input/output connector 160 and connection lines 155 connected to the input connectors 151 are drawn. When the horizontal-type tuner 42 is mounted, the shielding plate 80 similarly covers the tuner circuit board 30 to the vicinity of the horizontal-type tuner 42. Therefore, the shielding plate 80 can be used both for the tuner circuit board 30 on which the vertical-type tuner 41 is mounted and the tuner circuit board 30 on which the horizontal-type tuner 42 is mounted without adapting the configuration of the shielding plate 80. Furthermore, the shielding plate 80 serves to prevent the connection lines to the main circuit board or other components of the television set (not shown) from being affected by an undesirable radiation emitted from the tuner circuit board 30. With such a sharable shielding plate 80, only one type of shielding plate 80 is enough to prevent a plurality of types of tuner circuit boards 30, on which different types of tuners 41, 42 that tend to emit an undesirable radiation from the receiving input terminal 40b are mounted, from affecting the main circuit board or other components in an associated electronic apparatus (not shown) by the undesirable radiation. In this way, there are provided a tuner circuit board 30 having undesirable radiation preventing means on which a hybrid tuner 40 designed both for digital broadcasting and analog broadcasting is mounted that is used in a television set (not shown) with display means of CRT type, liquid crystal type or PDP type, a recording/reproducing device such as DVD and HDD, or a composite electronic apparatus incorporating the television set and the recording/reproducing device, and such an electronic apparatus. Furthermore, all the components of the tuner circuit board 30 other than the tuners 41, 42 are sharable, so that the tuner circuit board 30 can be used for a wide variety of products. Thus, it is possible to provide users with products that are less uneven in quality.

While an embodiment of the present invention has been described above, the present invention is not limited thereto and can be modified in various ways without departing from the spirit of the present invention. For example, the components of the tuner circuit board 30 can be arranged in an arbitrary manner as far as the tuner circuit board 30 can convert the digital-broadcasting or analog-broadcasting video/audio signal received by the television set or recording/reproducing device provided with the tuner circuit board 30 into a desired video/audio signal for transmission. Furthermore, the layout of the tuner circuit board 30 and the grounding section 170 is not limited to the embodiment described above and can be appropriately selected or modified taking into account the ease of use or design of the tuner circuit board 30 and the grounding section 170 in the housing of the television set or recording/reproducing device.

According to an implementation as set forth in Claim 1, in a tuner circuit board having undesirable radiation preventing means and an electronic apparatus having the tuner circuit board, the tuner circuit board comprising: a tuner section on which a hybrid tuner designed both for digital broadcasting and analog broadcasting can be mounted; a video/audio processing section that processes a received video/audio signal of digital broadcasting or analog broadcasting; an input/output connecting section connected to a main circuit board of the electronic apparatus; and a power supply section that supplies electric power to each section on the circuit board, both a vertical-type tuner and a horizontal-type tuner designed both for digital broadcasting and analog broadcasting can be mounted on the tuner section of the tuner circuit board, the tuner circuit board has, as the undesirable radiation preventing means, a grounding section that extends from one edge of the tuner circuit board at the side of the tuner section in a direction of protrusion of the horizontal-type tuner, separating means having a tear-off line is provided at the boundary between the grounding section and the tuner circuit board, the grounding section can be separated off by the separating means when the vertical-type tuner is mounted on the tuner circuit board, and the grounding section is not separated off so that a part of the horizontal-type tuner at the side of a receiving input terminal thereof protrudes above the grounding section when the horizontal-type tuner is mounted on the tuner circuit board. Since the grounding pattern is formed in the area of the tuner circuit board that lies under the horizontal-type tuner and would otherwise be discarded as an unnecessary part or would otherwise be an useless area without any grounding pattern, an undesirable radiation can be absorbed by the grounding section, which would otherwise be an useless area as described above, and be stabilized. As a result, a tuner circuit board improved in ability to prevent undesirable radiation and noise and a device incorporating the tuner circuit board can be provided at low cost.

According to an implementation as set forth in Claim 2, when evaluating and investigating the undesirable radiations of the vertical-type tuner and the horizontal-type tuner, the undesirable radiations of the tuner circuit board having the vertical-type tuner and the tuner circuit board having the horizontal-type tuner can be evaluated and investigated by alternately mounting the vertical-type tuner and the horizontal-type tuner on the tuner circuit board without the grounding section being separated off, rather than preparing a plurality of tuner circuit boards for different types of tuners. Thus, there is no need of fabricating a plurality of experimental tuner circuit boards for evaluation, and evaluation and investigation of the undesirable radiation of a plurality of tuners can be readily performed simply by alternately mounting the vertical-type tuner and the horizontal-type tuner on one tuner circuit board with an electronic component mounted thereon. As a result, the cost and the workload on engineers can be reduced, and the development time can be reduced. Furthermore, since the electronic apparatus can be designed regardless of what tuner is to be used, the degree of freedom of design is increased.

According to an implementation as set forth in Claim 3, after evaluation and investigation of the undesirable radiation are completed, if the tuner to be used for mass production is the vertical-type tuner, the grounding section can be separated off by the separating means, or if the tuner to be used for mass production is the horizontal-type tuner, the grounding section is not separated off so that the part of the horizontal-type tuner at the side of the receiving input terminal thereof protrudes above the grounding section, thereby providing a tuner circuit board for mass production on which a predetermined tuner selected from among a plurality of kinds of tuners is mounted and which is dedicated to a plurality of kinds of electronic apparatus. Thus, the number of steps required for purchase of materials of the board and electronic components, inventory management thereof, and start of mountings of the electronic components can be reduced.

According to an implementation as set forth in Claim 4, the tuner circuit board has a circuit arrangement that allows the tuner circuit board to be shared by the vertical-type tuner and the horizontal-type tuner, and the pattern on the circuit board is the same for the vertical-type tuner and the horizontal-type tuner, so that the circuit arrangement, layout and wiring pattern of the tuner circuit board except for those associated with the tuner can be the same for the vertical-type tuner and the horizontal-type tuner. Thus, the time for evaluation and investigation of the prototype can be reduced, and the complexity of the work of engineers in the development stage can be reduced. Furthermore, in the case where the tuner circuit board on which a hybrid tuner designed both for digital broadcasting and analog broadcasting is used in a television set having display means, such as a CRT display device or a flat panel display such as a PDP display or a liquid crystal display, a recording/reproducing device such a DVD or HDD or a composite electronic apparatus incorporating both the television set and the recording/reproducing device, the tuner circuit boards for the vertical-type tuner and the horizontal-type tuner can share all the components except for the tuner, including the board, the circuit and components for preventing undesirable radiation and noise, and thus, one tuner circuit board can be used for a wide variety of products. As a result, users can be provided with products that are less uneven in quality.

According to an implementation as set forth in Claim 5, since the area of the grounding section that overlaps with the protruding part of the horizontal-type tuner at the side of the receiving input terminal is an overlapping area of the grounding section, the receiving input terminal of the horizontal-type tuner, which is easily affected by the undesirable radiation because it protrudes from a shield covering the tuner, is disposed close to the overlapping area of the grounding section after the horizontal-type tuner is mounted on the tuner circuit board, so that the undesirable radiation can be absorbed by the grounding section and thus can be prevented. Furthermore, since the area of the grounding section that lies on the other side of the receiving input terminal of the protruding horizontal-type tuner and does not overlap with the horizontal-type tuner is a free area in which no electronic component or the like is placed, the area in the rear of the horizontal-type tuner can be an area that is hardly affected by the undesirable radiation.

According to an implementation as set forth in Claim 6, one grounding pattern is formed over substantially the whole surface of the grounding section extending from the tuner circuit board. Thus, the undesirable radiation can be efficiently absorbed by substantially the whole area of the wide grounding section.

According to an implementation as set forth in Claim 7, since the video/audio processing section of the tuner circuit board has a digital circuit block and an IF block, and when the tuner circuit board is connected to the main circuit board of the electronic apparatus, the digital circuit block and the IF block are disposed at a distance from the power supply section, the power supply section can be spaced apart from the digital circuit block and the IF block that are likely to emit an undesirable radiation, which is emitted by a digital circuit system and a harmonic signal system, thereby reducing the effect of the undesirable radiation. Furthermore, since an input/output connector for supplying electric power from the main circuit board of the electric apparatus to the tuner circuit board and an input/output connector grounded via the main circuit board of the electronic apparatus are disposed close to the power supply section, the length of a connection line from the electronic apparatus and the wiring pattern on the tuner circuit board can be minimized, so that the effect of the digital circuit block and the IF block, which are likely to emit an undesirable radiation, can be minimized.

According to an implementation as set forth in Claim 8, in the case where the horizontal-type tuner, whose receiving input terminal is close to the surface of the tuner circuit board, is mounted, and the spatial distance between the receiving input terminal and a wiring pattern on the tuner circuit board is short, the power supply section is disposed at a distance from the receiving input terminal of the horizontal-type tuner, and a free area in which no electronic component is placed is provided in the vicinity of the power supply section. Since the receiving input terminal of the horizontal-type tuner is disposed close to the digital circuit block and the IF block, and the receiving input terminal absorbs and emits the undesirable radiation emitted from the digital circuit block and the IF block, the power supply section, which is easily affected by the undesirable radiation, is disposed at a distance from the receiving input terminal, and the free area is formed in the grounding section to absorb and stabilize the undesirable radiation, thereby reducing the effect of the undesirable radiation on the power supply section. As a result, even when the horizontal-type tuner is mounted, and the tuner circuit board has a disadvantageous arrangement in which an adequate spatial distance is not maintained between the receiving input terminal and the tuner circuit board, the tuner circuit board can be highly resistant to the undesirable radiation or noise.

According to an implementation as set forth in Claim 9, since a shielding place that covers the tuner circuit board can be shared by the vertical-type tuner and the horizontal-type tuner, only one sharable shielding plate, which can be used as a cover for a plurality of kinds of tuner circuit boards that are likely to emit an undesirable radiation, is enough to reduce the effect of the undesirable radiation on the main circuit board or the like of the electronic apparatus.

## Claims

1. An electronic apparatus having a tuner circuit board, the tuner circuit board comprising: a tuner section on which a hybrid tuner designed both for digital broadcasting and analog broadcasting can be mounted; a video/audio processing section that processes a received video/audio signal of digital broadcasting or analog broadcasting; an input/output connecting section connected to a main circuit board of the electronic apparatus; and a power supply section that supplies electric power to each section on the circuit board, **characterized in that** both a vertical-type tuner and a horizontal-type tuner designed both for digital broadcasting and analog broadcasting can be mounted on said tuner section of said tuner circuit board, said tuner circuit board has, as undesirable radiation preventing means, a grounding section that extends from one edge of the tuner circuit board at the side of the tuner section in a direction of protrusion of said horizontal-type tuner, separating means having a tear-off line is provided at the boundary between the grounding section and said tuner circuit board, said grounding section can be separated off by said separating means when said vertical-type tuner is mounted on the tuner circuit board, and said grounding section is not separated off so that a part of said horizontal-type tuner at the side of a receiving input terminal thereof protrudes above said grounding section when said horizontal-type tuner is mounted on the tuner circuit board.

2. The electronic apparatus having the tuner circuit board according to Claim 1, **characterized in that** when evaluating and investigating the undesirable radiations of said vertical-type tuner and said horizontal-type tuner, the undesirable radiations of the tuner circuit board having the vertical-type tuner and the tuner circuit board having the horizontal-type tuner can be evaluated and investigated by alternately mounting the vertical-type tuner and the horizontal-type tuner on the tuner circuit board without the grounding section being separated off.

3. The electronic apparatus having the tuner circuit board according to Claim 1 or 2, **characterized in that** after evaluation and investigation of said undesirable radiation are completed, if the tuner to be used for mass production is said vertical-type tuner, said grounding section can be separated off by said separating means, or if the tuner to be used for mass production is said horizontal-type tuner, said grounding section is not separated off so that the part of said horizontal-type tuner at the side of the receiving input terminal thereof protrudes above said grounding section, thereby providing a tuner circuit board for mass production on which a predetermined tuner selected from among a plurality of kinds of tuners is mounted and which is dedicated to a plurality of kinds of electronic apparatus.

4. The electronic apparatus having the tuner circuit board according to any one of Claims 1 to 3, **characterized in that** said tuner circuit board has a circuit arrangement that allows the tuner circuit board to be shared by the vertical-type tuner and the horizontal-type tuner, and the pattern on the circuit board is the same for the vertical-type tuner and the horizontal-type tuner.

5. The electronic apparatus having the tuner circuit board according to any one of Claims 1 to 4, **characterized in that** the area of said grounding section that overlaps with the protruding part of said horizontal-type tuner at the side of the receiving input terminal is an overlapping area of the grounding section, and the area of said grounding section that lies on the other side of the receiving input terminal of the protruding horizontal-type tuner and does not overlap with the horizontal-type tuner is a free area in which no electronic component or the like is placed.

6. The electronic apparatus having the tuner circuit board according to any one of Claims 1 to 5, **characterized in that** one grounding pattern is formed over substantially the whole surface of the grounding section extending from the tuner circuit board.

7. The electronic apparatus having the tuner circuit board according to any one of Claims 1 to 6, **characterized in that** the video/audio processing section of said tuner circuit board has a digital circuit block and an IF block, and when said tuner circuit board is connected to the main circuit board of said electronic apparatus, the digital circuit block and the IF block are disposed at a distance from the power supply section, and an input connector for supplying electric power from the main circuit board of the electric apparatus to the tuner circuit board and an input connector grounded via the main circuit board of the electronic apparatus are disposed close to the power supply section.

8. The electronic apparatus having the tuner circuit board according to any one of Claims 1 to 7, **characterized in that** in the case where the horizontal-type tuner, whose receiving input terminal is close to the surface of said tuner circuit board, is mounted, and the spatial distance between the receiving input terminal and a wiring pattern on the tuner circuit board is short, the power supply section is disposed at a distance from the receiving input terminal of said horizontal-type tuner, and a free area in which no electronic component is placed is provided in the vicinity of the power supply section.

9. The electronic apparatus having the tuner circuit board according to any one of Claims 1 to 8, **characterized in that** a shielding place that covers said tuner circuit board can be shared by the vertical-type tuner and the horizontal-type tuner.
